# EUROPÄISCHE PATENTSCHRIFT

(11) **EP 1 224 618 B1**
(45) Veröffentlichungstag und Bekanntmachung des Hinweises auf die Patenterteilung: **16.04.2003**
(21) Anmeldenummer: 00966130.7
(22) Anmeldetag: 06.10.2000
(51) Int. Cl.: G06K 19/077

(54) **VERFAHREN ZUR HERSTELLUNG KONTAKTLOSER CHIPKARTEN SOWIE ZUR HERSTELLUNG VON ELEKTRISCHEN EINHEITEN, BESTEHEND AUS CHIPS MIT KONTAKTELEMENTEN**
METHOD FOR PRODUCTION OF CONTACTLESS CHIP CARDS AND FOR PRODUCTION OF ELECTRICAL UNITS COMPRISING CHIPS WITH CONTACT ELEMENTS
PROCEDE POUR PRODUIRE DES CARTES A PUCE SANS CONTACT ET DES UNITES ELECTRIQUES CONSTITUEES DE PUCES A ELEMENTS DE CONTACT

(30) Priorität: 08.10.1999 DE 19948555
(43) Veröffentlichungstag der Anmeldung: 24.07.2002
(73) Patentinhaber: Plettner, Andreas, 82340 Feldafing (DE)
(72) Erfinder: Plettner, Andreas, 82340 Feldafing (DE)
(74) Vertreter: Grünecker, Kinkeldey, Stockmair & Schwanhäusser Anwaltssozietät
(86) Internationale Anmeldenummer: EP0009818
(87) Internationale Veröffentlichungsnummer: WO01027871

(56) Entgegenhaltungen:
- EP-A- 0 928 016
- FR-A- 2 761 527

## Beschreibung

Die vorliegende Erfindung bezieht sich auf ein Verfahren zur Herstellung von elektrischen Einheiten, bestehend aus Chips mit Kontaktelementen gemäss dem Oberbegriff des Patentanspruchs 1.

Kontaktlose Chipkarten lösen zunehmend kontaktbehaftete Chipkarten ab. Der Grund hierfür dürfte insbesondere darin zu sehen sein, dass kontaktlose Chipkarten eine einfachere Handhabung gestatten, robuster ausgestaltet sind und somit eine geringere Störanfälligkeit aufweisen und eine Reihe interessanter neuer Möglichkeiten in der Anwendung bieten, da sie nicht in ein Lesegerät eingesteckt werden müssen.

Kontaktlose Chipkarten weisen bekanntermaßen eine in die Chipkarte eingebrachte Leiterschleife oder Antenne auf, mittels der der ebenfalls in die Chipkarte eingebrachte Chip mit der Außenwelt kommunizieren kann. Hierzu muss während der Herstellung der kontaktlosen Chipkarte die Leiterschleife mit den Kontakten des Chips bzw. des entsprechenden Moduls verbunden werden. Zur Erzielung dieser elektrischen Verbindung zwischen Leiterschleife und Chip würden bereits mehrere Verfahren vorgeschlagen, wobei sich insbesondere die folgenden Verfahren durchgesetzt haben.

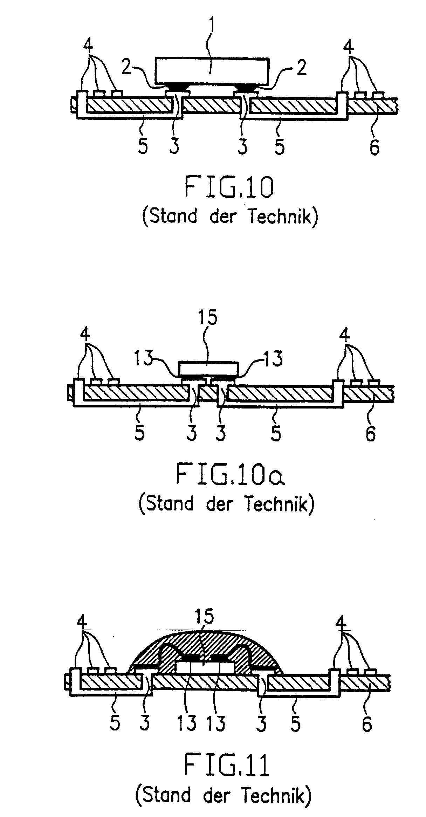

Fig. 10 verdeutlicht das Prinzip, wie nach dem Stand der Technik üblicherweise eine elektrische Verbindung zwischen einem Chipmodul 1 und einer Leiterschleife 4 hergestellt wird.

Ein Chipmodul 1, in dessen Inneren sich ein nicht dargestellter Chip befindet, weist von außen zugängliche Kontakte 2 auf, die beispielsweise mittels eines Löt-, Klebeoder Drahtbondprozesses mit den eigentlichen Kontakten des Chips verbunden sind. Mit der Bezugsziffer 3 sind Kontaktanschlüsse angedeutet, die über einen elektrischen Leiter 5 zu der auf einem Chipkartenkörper 6 aufgebrachten Leiterschleife 4 eine elektrische Verbindung herstellen. Um letztendlich eine Kontaktierung zwischen der Leiterschleife 4 einerseits und dem Chip andererseits zu erreichen, müssen die Kontakte 2 mit den Kontaktanschlüssen 3 elektrisch leitend verbunden werden. Hierzu wird das Modul 1 mittels eines Werkzeuges mit der kontaktbehafteten Seite auf die Kontaktanschlüsse 3 aufgesetzt.

Eine andere Möglichkeit besteht darin, den Chip 15 selbst, d.h. nicht in Modulform, sondern "nackt" auf die Kontaktanschlüsse 3 aufzusetzen, wie in Fig. 10a dargestellt wird. Bei dieser Variante muß der Chip 15 mit seiner "aktiven Seite", d.h. der Seite, die die Anschlußflächen 13 trägt, auf die Kontaktanschlüsse 3 aufgesetzt werden. Hierzu muß der Chip "geflippt" werden, was ein zweifaches Greifen des Chips 15 vom Wafer bzw. vom Trägerband erforderlich macht.

Fig. 11 verdeutlicht eine andere Möglichkeit, wie nach dem Stand der Technik eine elektrische Verbindung zwischen einem Chip 15 und einer Leiterschleife 4 mittels eines Drahtbond-Verfahrens hergestellt werden kann.

Um in diesem Fall eine Kontaktierung zwischen der Leiterschleife 4 einerseits und dem Chip 15 andererseits zu erreichen, wird der Chip auf den Chipkartenkörper 6 aufgebracht, und die Anschlußflächen 13 werden mittels Drahtbonden mit den Kontaktanschlüssen 3 elektrisch leitend verbunden. Ersichtlicherweise muß der Chip 15 bei dieser Lösung nicht mehr geflippt werden. Allerdings bedingen die durch das Drahtbonden entstandenen Drahtverbindungen 34 eine größere Gesamtbauhöhe der Chipkarte und müssen außerdem durch eine solide Schutzschicht geschützt werden.

Eine andere Art der Kontaktierung ist aus DE 196 09 636 C1 bekannt. Gemäss der dort angegebenen Lösungsmöglichkeit wird ein Chipmodul derart in eine Aussparung des Chipkartenkörpers eingebracht, dass die auf der Oberfläche des Moduls vorhandenen Kontakte bündig mit Leiterbahnen auf der Oberfläche des Körpers abschließen, sodass hierdurch eine Kontaktierung der Leiterschleife mit den Kontakten des Moduls erzielt werden kann. Nachteilig bei dieser Ausführung ist, dass die Tiefe der Aussparung äußerst genau bemessen sein muss, um das plane Abschließen der beiden Kontakte zu ermöglichen.

WO-A-98 52224 beschreibt ein Verfahren zum lithographischen Herstellen mikroelektronischer Kontaktstrukturen, die bereits auf Waferebene auf Halbleiterbauelemente aufgebracht werden können, indem auf ein Halbleitersubstrat mit Anschlussflächen verschiedene Schichten aufgebracht werden, z.B. durch Sputtem und unter Verwenden geeigneter Masken. Diese mikroelektronischen Kontaktstrukturen müssen allerdings in einem komplizierten lithographischen Verfahren hergestellt werden, vergrößern die Gesamtbauhöhe entsprechend erstellter Chipkarten und weisen keine Flexibilität auf.

FR-A-2 761 527 beschreibt ein Herstellungsverfahren von elektrischen Einheiten, bestehend auf Chips und Gold- bzw. Aluminiumdrehten mittels der im Stand der Technk gebräuchlichen Wire-Bonding-Technik. Hierbei wird von einem Waferverband ausgegangen, der eine Vielzahl von Chips aufweist, die In Reihen und Spalten angeordnet und jewells durch sagestraßen voneinander getrennt sind. Die Gold- bzw; Aluminiumdrahte werden zwischen Anschlussflächen von Chips und Pads, die sich in der benachbarten Sagestraße befinden, vorgenommen, so dass jeweils zwei Anschlussflachen benachbarter Chips Ober den entsprechenden Pad in der zwischen den beiden Chips liegenden Sägestraße verbunden werden. Das Auftrennen der derart hergestellten Verbindungen zwischen den Anschlussflächen benachbarter Chips erfolgt beim Sägen des Wafers, wodurch die Drahtverbindungen getrennt werden. Somit erhält man elektrische Einheiten, bestehend aus Chips mit Gold- bzw. Aluminiumdrähten.

Ausgehend von dem bekannten Stand der Technik liegt der vorliegenden Erfindung die Aufgabe zugrunde, eine Möglichkeit zu schaffen, Kontakte zwischen einem Chip und der Antenne einer kontaktlosen Chipkarte einfacher und insbesondere schneller zu erstellen, wobei diese Kontakte eine hohe elektrische und mechanische Zuverlässigkeit aufweisen sollen.

Diese Aufgabe wird durch den Gegenstand des Patentanspruchs 1 gelöst Bevorzugte Ausgstaltungen der Erfindung sind Gegenstand der Unteransprüche.

Insbesondere wird die Aufgabe der vorliegenden Erfindung durch ein Verfahren zur Herstellung von elektrischen Einheiten, bestehend aus Chips mit Kontaktelementen gelöst, wobei die Kontaktelemente geeignet sind, direkt mit Kontaktanschlüssen externer elektrischer Bauelemente elektrisch leitend verbunden zu werden, wobei die Verbindung der Kontaktelemente mit den Chips erfolgt, bevor die einzelnen Chips aus der durch den Wafer vorgegebenen Gruppierung, bestehend aus Reihen und Spalten, ausgelöst werden, und die Kontaktelemente aus einer auf die Chips aufzubringenden metallisierten Kunststoff-Folie bzw. metallischen Folie bestehen.

Gemäß einem besonderen Aspekt der vorliegenden Erfindung werden Chip-Kontaktelemente-Einheiten auf Waferebene erstellt, wobei diese Einheiten dazu dienen, eine elektrische Verbindung zwischen dem "nackten" Chip und einer in einem Chipkartenkörper vorhandenen Leiterschleife bzw. Antenne bereitzustellen. Die Kontaktelemente sind dabei vorzugsweise Anschlussfähnchen, die auf Waferebene unmittelbar mit den Anschlussflächen des Chips verbunden werden. Die vorzugsweise als Anschlussfähnchen ausgeführten Kontaktelemente haben Abmessungen, die eine problemlose Kontaktierung mit den Kontaktanschlüssen von Leiterschleifen bzw. Antennen ermöglichen, wobei die Gesamtbauhöhe der Chipkarte aufgrund der flach abstehenden Anschlussfähnchen höchstens unwesentlich vergrößert wird. Insbesondere können diese Kontaktelemente so lang ausgeführt werden, daß sie eine Verbindung des Chips mit Kontaktanschlüssen ermöglichen, die auf der gegenüberliegenden Seite der Anschlussflächen des Chips liegen, wodurch das weiter oben Beschriebene, im Stand der Technik übliche, Umdrehen mittels Flip-Chip-Prozess vermieden wird. Die eigentliche Kontaktierung mit der Antenne kann äußerst einfach und schnell erfolgen.

Neben den oben beschriebenen Vorteilen weist das angegebene Verfahren insbesondere den Vorteil auf, daß eine effiziente Erstellung von Chip-Kontaktelemente-Einheiten bereits auf Waferebene erfolgt und somit ein mühsames einzelnes Kontaktieren jedes individuellen Chips nicht mehr erforderlich ist. Es können somit quasi gleichzeitig ganze Reihen von Chips auf einem Wafer kontaktiert werden und für den Fall, daß die einzelnen Reihen des Wafers vorab in den richtigen Abstand zueinander gebracht werden, kann sogar ein quasi gleichzeitiges Kontaktieren aller Anschlussflächen der Chips mit einer über die Chips des Wafers gelegten Folie erreicht werden. Während der Erstellung dieser Chip-Kontaktelemente-Einheiten bleiben die Chips in einer Gruppierung zueinander bestehen, die im wesentlichen der durch die Waferherstellung vorgegebenen Gruppierung entspricht, wobei selbstverständlich eine Erweiterung der Abstände zwischen den einzelnen Chips durch geeignete Mittel erreicht werden sollte. Das Aufspreizen der einzelnen Chipreihen bzw. Chipspalten kann dabei durch geeignete feinmechanische Geräte erfolgen, wobei zur Sicherung der geeigneten Ausrichtung vorzugsweise eine Klebefolie zum Einsatz kommt.

Wie erwähnt, können die Anschlussflächen der Chips zumindest reihen- oder spaltenweise quasi gleichzeitig kontaktiert werden für den Fall, daß Kontaktfolien Verwendung finden, die die Breite des gesamten Wafers abdecken. Alternativ können als Folien auch Bänder verwendet werden, die jeweils über Reihen oder Spalten von Chips abgerollt werden.

Die letztendlich erstellte Chip-Kontaktelemente-Einheit ist äußerst robust, da die Kontaktelemente aufgrund ihrer Abmessungen und der vorzugsweise in entsprechender Größe ausgeführten Anschlussflächen hohen Zugbelastungen standhalten, sodass ein Aufkleben der Chips auf den Chipkartenkörper unter Umständen nicht mehr erforderlich ist, wodurch die Prozesszeiten durch ein Wegfallen der Verweilzeit beim Kleben verkürzt werden. Der Chip ist somit nicht mit dem Chipkartenkörper verbunden, was eine effiziente Zugentlastung des Chips bewirkt, da der Chipkartenkörper gedehnt oder gebogen werden kann, ohne dass der Chip selbst beansprucht wird. Für den Fall, daß der Chip mit einer Abdeckmasse geschützt werden soll, kann die Zugentlastung dadurch erreicht werden, daß die Abdeckmasse leichter dehnbar ist als der Chipkartenkörper. Des weiteren kann der Schutz des Chips auch durch eine Abdeckfolie erreicht werden, die über den Chip und den Chipkartenkörper auflaminiert wird, wobei eine klebende oder haftende Verbindung der Abdeckfolie mit dem Chip oder den Kontaktelementen vermieden werden muß, um die oben beschriebene Zugentlastung aufrecht zu erhalten.

Für den Fall, daß ein Verbinden des Chips mit dem Chipkartenkörper, z.B. mittels Kleben, wünschenswert ist, kann die oben beschriebene Zugentlastung des Chips dadurch erreicht werden, dass der verwendete Verbindungskleber zwischen Chip und Chipkartenkörper so ausgewählt wird, dass dieser dehnbarer bzw. weicher als der Chipkartenkörper ist. Des weiteren kann der Chipkartenkörper selbst in der Umgebung des Chips dehnbarer sein und somit die Zugentlastung des Chips bewirken. Eine weitere Möglichkeit für die Zugentlastung des Chips besteht darin, Sollbiegestellen um den Chipbereich anzuordnen, was entweder durch eine Perforation des Chipkartenkörpers, durch das Aufbringen eines anderen, dehnbaren Materials oder durch ein Verdünnen des Chipkartenkörpers an den entsprechenden Steilen erreicht werden kann. Wird der Chipkartenkörper gedehnt oder gebogen, so erfolgt die Dehnung bzw. Biegung an den vorgesehenen Sollbiegestellen, sodass der Chip wiederum zugentlastet wird. Dieser Effekt kann auch dadurch erzielt werden, daß anstelle eines Abschwächens des Chipkartenkörpers um den Chipbereich herum ein Verstärken dieses Chipbereiches bzw. der Chipumgebung tritt, wodurch erreicht wird, daß der Chipbereich weniger dehnbar ist als seine Umgebung.

Es ist zu erwähnen, daß verschiedene der oben beschriebenen Verfahren zur Zugentlastung des Chips miteinander kombiniert werden können, um somit den gewünschten Effekt noch zu verstärken. Beispielsweise kann für den Fall, daß der Chip nicht mit dem Chipkartenkörper verklebt wird, zusätzlich eine Verstärkung des Chipbereichs sowie eine Perforation der Umgebung des Chipbereichs vorgesehen sein.

In allen oben beschriebenen Fällen, und unabhängig von diesen, kann zusätzlich zur Zugentlastung des Chips auch eine Zugentlastung der Kontaktelemente hinzutreten. In diesem Fall werden die Kontaktelemente so ausgelegt, dass ihre Länge grösser ist als der Abstand zwischen den Anschlussflächen des Chips und den Kontaktanschlüssen der Leiterschleife bzw. Antenne. Dadurch werden die Kontaktelemente bei der Kontaktierung nicht straff gespannt, sondern wellenförmig zwischen dem Chip und den Kontaktanschlüssen angebracht. Durch diese Wellenförmigkeit der Kontaktelemente kann eine Zugentlastung der Kontaktelemente erreicht werden.

Insbesondere können die Chip-Kontaktelemente-Einheiten durch geeignete Mittel reihen- bzw. spaltenweise auf Trägerbänder aufgebracht werden, wobei durch entsprechende Verarbeitungsschritte auch das Erstellen von "Endlosbändern" möglich ist. Eine vorteilhafte Variante besteht darin, die Chip-Kontaktelementeeinheiten so auf Trägerbänder aufzubringen, daß die Kontaktelemente orthogonal zu beiden Seiten des Trägerbandes abstehen. Dies führt zu einer äußerst einfachen Handhabung beim Einbringen der Chips in den Kartenkörper. Gemäß einer weiteren Variante werden die Kontaktelemente einer Reihe bzw. Spalte nicht voneinander getrennt und bilden somit eine selbsttragende Bandstruktur. Ein Trägerband kann bei dieser Variante entfallen.

Die eigentliche Form der Kontaktelemente ergibt sich vorzugsweise mittels Ausschneiden dieser aus der aufgebrachten Kontaktfolie, wobei das Ausschneiden vorzugsweise mittels Laser erfolgt. Alternativ hierzu kann die aufgebrachte Folie bereits vorstrukturiert sein, so daß sich umfangreiche Schneideschritte einsparen lassen.

Bevorzugte Ausführungen der vorliegenden Erfindung werden im folgenden unter Bezugnahme auf die beiliegenden Zeichnungen näher erläutert. Dabei zeigen die Zeichnungen im einzelnen:
Fig. 1 eine schematische Seitenansicht einer Vorrichtung zum Herstellen von elektrischen Einheiten, bestehend aus Chips mit Kontaktelementen;
Fig. 2 eine schematische Arisicht eines Wafers in einem Halterahmen mit beispielhaften Ausführungsformen der zu verwendenden Chips;
Fig. 3 und 4 schematische Ansichten eines Wafers mit vier beispielhaft angedeuteten Möglichkeiten zur Anbringung von Kontaktelementen;
Fig. 3a und 3b schematische Seitenansichten von Waferspalten mit beispielhaft angebrachten Kontaktelementen;
Fig. 5 und 6 schematische Ansichten aufgespreizter Waferreihen mit vier beispielhaft angedeuteten Möglichkeiten zur Anbringung von Kontaktelementfolie;
Fig. 5a und 6a schematische Seitenansichten aufgespreizter Waferspalten mit beispielhaft aufgebrachten Kontaktelementen;
Fig. 7 eine schematische Ansicht eines Trägerbandes mit vier beispielhaft angedeuteten Möglichkeiten zur Aufnahme von Chip-Kontaktelemente-Einheiten;
Fig. 8 eine schematische Ansicht aufgespreizter Waferspalten auf verschiedenen Trägerbändern mit vier beispielhaft angedeuteten Möglichkeiten zur Aufnahme von Chip-Kontaktelemente-Einheiten;
Fig. 8a eine schematische Ansicht von Waferspalten, bei denen die unaufgetrennten Kontaktelemente die Funktion von Trägerbändern übernehmen;
Fig. 9 und 9a schematische Ansichten einer kontaktlosen Chipkarte mit Antenne und ankontaktierter Chip-Kontaktelemente-Einheit;
Fig. 9b eine schematische Seitenansicht einer ankontaktierten Chip-Kontaktelemente-Einheit;
Fig. 9c schematische Seitenansichten einer ankontaktierten, mit dem Chipkartenkörper verbundenen Chip-Kontaktelemente-Einehit mit zugentlastetem Chip-Bereich;
Fig. 9d schematische Seitenansichten einer ankontaktierten Chip-Kontaktelemente-Einheit mit zugentlastetem Chip-Bereich;
Fig. 10 und 10a schematische Darstellungen einer Modul- bzw. Chipkontaktierung gemäß dem Stand der Technik, und
Fig. 11 eine schematische Darstellung einer Chipkontaktierung gemäß dem Stand der Technik mittels Drahtbondverfahren.

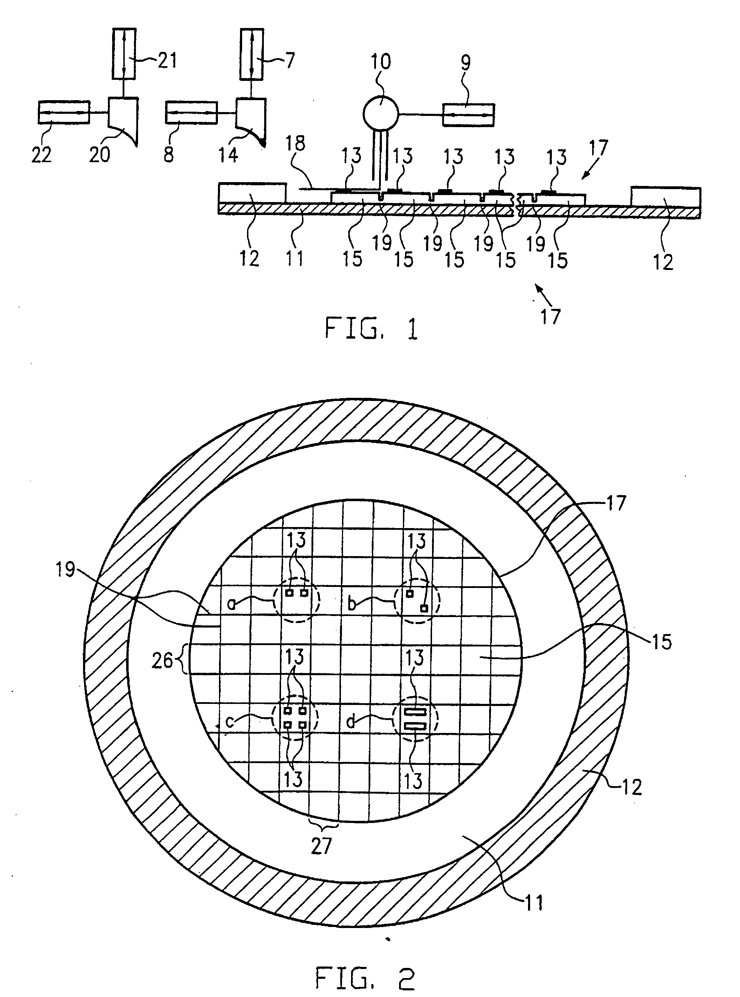

In Fig. 1 wird eine schematische Seitenansicht einer Vorrichtung zum Abrollen einer Folie 16 über einen Wafer 17 dargestellt, sowie eine Querschnittsansicht einer Verbindungsvorrichtung 14 und eine Querschnittsansicht einer Trennvorrichtung 20.

Der Wafer 17 umfasst eine Vielzahl von Chips 15, die durch eine Vielzahl von Sägestrassen 19 voneinander getrennt sind, und wird aufgenommen von einem Halterahmen 12 mit einer Sägefolie 11. Zum Vereinzeln dieser Chips 15 wird der Wafer entlang der verschiedenen Sägestraßen 19 gesägt. Anstelle eines Durchsägens des Wafers 7 entlang der Sägestraßen 19 kann ein Ritzen treten, d.h., die Sägestraßen 19 werden nicht bis auf die Sägefolie 11 "durchgesägt" und zu einem späteren Zeitpunkt gebrochen.

Über den Wafer 17 wird mittels einer Abrollvorrichtung 10 vorzugsweise eine metallisierte Kunststoff-Folie bzw. metallische Folie 16 abgerollt. Besonders bevorzugterweise wird eine Goldfolie oder eine mit Gold kaschierte oder bedampfte Kunststoff-Folie verwendet. Außerdem kann die Goldmetallisierung auf der Kunststoff-Folie strukturiert sein, um hierdurch die Form der Kontaktelemente 18 bereits weitgehend vorzugeben und spätere Schneideschritte weitgehend zu vermeiden. Hierbei kann die Folie 16 auf einer Rolle mittels eines Antriebes 9 in Richtung des Doppelpfeils horizontal hin- und herbewegt werden.

Die Folie 16 wird nun mittels einer Verbindungsvorrichtung 14 mit den Anschlussflächen 13 der einzelnen Chips 15 verbunden, was durch Löten, Bonden oder Kleben vorzugsweise während des Abrollens der Folie 16 über den Wafer 17 geschehen kann. Alternative Ausführungsformen erlauben die Verbindung der Folie 16 mit den Anschlussflächen 13 z.B. auch nach Beendigung des Abrollens der Folie 16 über den ganzen Wafer 17. Die Verbindungsvorrichtung 14 kann mittels eines Antriebes 8 horizontal, bzw. mittels eines Antriebes 7 vertikal hin- und herbewegt werden.

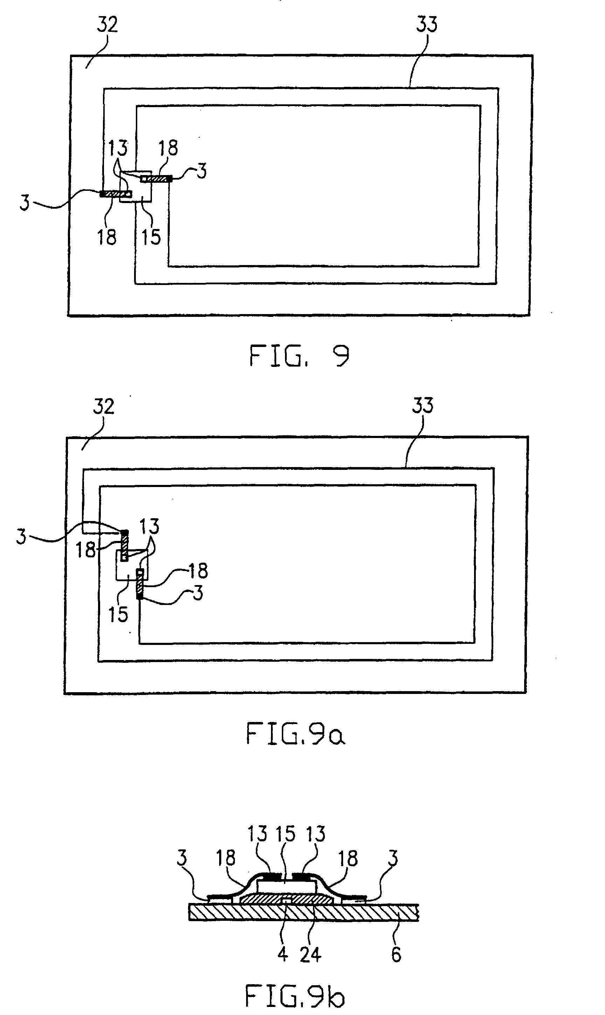

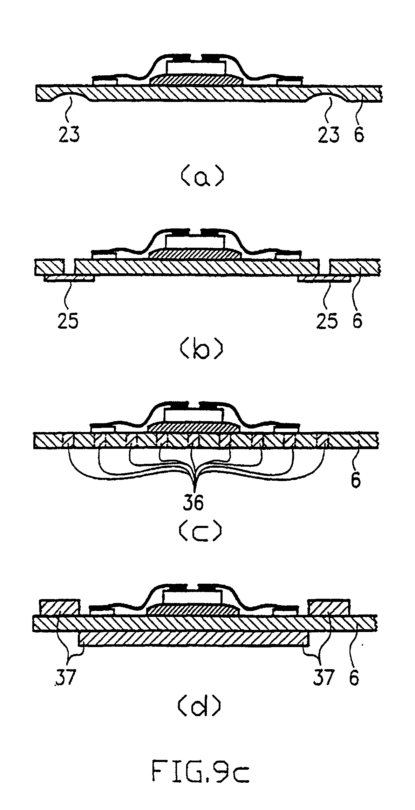

Abschließend wird die Folie 16 mit einer Trennvorrichtung 20, z.B. mittels eines Lasers, in die einzelnen Kontaktelemente 18 aufgetrennt. Die Trennvorrichtung 20 kann mittels eines Antriebes 22 horizontal, bzw. mittels eines Antriebes 21 vertikal hin- und herbewegt werden. Andere Ausführungsformen sehen vor, z.B. die Verbindung der Folie 16 mit den Anschlussflächen 13 und die anschließende Trennung in die einzelnen Kontaktelemente 18 mittels einer einzigen Vorrichtung durchzuführen. Durch das Trennen der Folie 16 in die einzelnen Kontaktelemente 18 entstehen Chip-Kontaktelemente-Einheiten, die dann durch verschiedene Möglichkeiten für die weitere Verarbeitung präpariert werden. Die so auf Waferebene entstandenen Einheiten, bestehend jeweils aus Chip 15 mit angeschlossenen Kontaktelementen 18, wie z.B. Anschlussfähnchen, weisen neben einer einfachen und insbesondere schnellen Herstellungsart den Vorteil auf, dass der Chip später beim Einbringen in die Chipkarte nicht mehr gedreht, d.h. "geflippt" werden muss, da die Kontaktelemente 18 eine Verbindung zwischen den obenliegenden Anschlussflächen 13 des nicht-gedrehten Chips 15 und den untenliegenden Kontaktanschlüssen 3 einer Leiterschleife bzw. Antenne 23 ermöglichen, wie dies in Zusammenhang mit der Fig. 9a beschrieben ist.

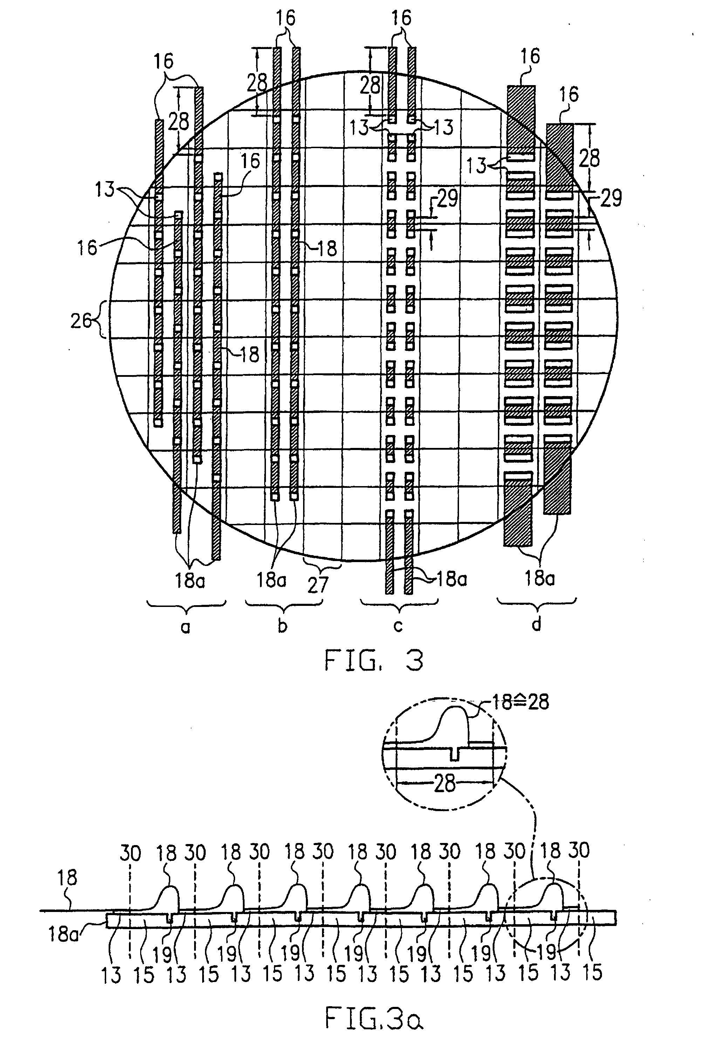

Die einzelnen Schritte, die zur Bildung der Chip-Kontaktelemente -Einheiten benötigt werden, werden anhand der Figuren 2-6a beschrieben.

In Fig. 2 ist der Wafer 17 von Fig. 1 in Draufsicht abgebildet. Der Wafer 17 weist eine Vielzahl in Reihen 26 und Spalten 27 angeordneter Chips 15 auf, die durch eine Vielzahl von Sägestrassen 19 voneinander getrennt sind und jeweils zwei oder mehr Anschlussflächen 13 aufweisen. Über diese Anschlussflächen 13 kann eine elektrische Verbindung jedes einzelnen Chips 15 mit Kontaktanschlüssen 3 externer elektrischer Bauelemente 4 (s. Fig. 10) zu einem späteren Zeitpunkt hergestellt werden. Wie in Fig. 2 beispielhaft gezeigt, sind verschiedene Anordnungsmöglichkeiten a - d für die Anschlussflächen 13 auf den Chips 15 möglich.

Die Anordnungsmöglichkeit a) zeigt zwei Anschlussflächen 13, die auf der Oberfläche des Chips 15 diagonal zueinander angeordnet sind, in b) befinden sich beide Anschlussflächen 13 parallel zueinander im selben Abstand zu einer Seite des Chips 15, in c) sind vier Anschlussflächen 13 jeweils in den Ecken des Chips 15 abgebildet und in d) sind zwei breite Anschlussflächen 13 jeweils parallel zu zwei gegenüberliegenden Seiten des Chips 15 dargestellt.

Zum Vereinzeln der Chips 15 wird der Wafer 17 gesägt. Um die Gruppierung der einzelnen Chips 15 in Waferform auch nach dem Sägen beibehalten zu können, wird der Wafer 17 vor dem Sägen vorzugsweise auf eine klebende Sägefolie 11 aufgebracht, durch die die gezeigte Anordnung der Chips 15 in ihren Originalabständen auch nach dem Sägen gesichert wird. Die Sägefolie 11 könnte hierbei auch durch ein anderes Substrat (nicht gezeigt) ersetzt werden. Der Halterahmen 12 unterstützt zusätzlich das Zusammenhalten der Chipgruppierung in Waferform, da er ein unbeabsichtigtes Dehnen der Sägefolie 11 verhindert.

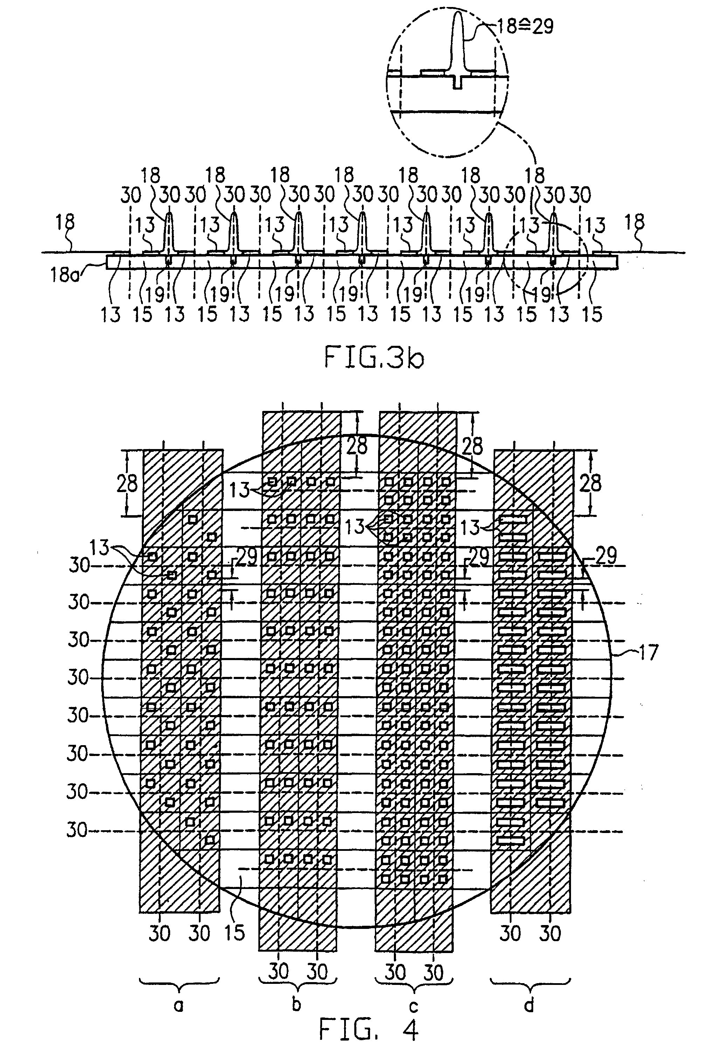

Wie in Fig. 3 schematisch dargestellt, werden anschließend durch Anbringen einer über den Wafer 17 abgerollten Folie 16, Kontaktelemente 18 mit den Anschlussflächen 13 der in Waferform gruppierten Chips 15 verbunden, wobei die verschiedenen angedeuteten Varianten a) - d) bedingt sind durch die verschiedenen Anordnungsmöglichkeiten der Anschlussflächen 13 auf den Chips 15, gemäss Fig. 2, a-d.

Unabhängig von der Anordnungsmöglichkeit gemäss Fig. 2, a - d, werden im Folgenden mit dem Bezugszeichen 18a alle Anschlussflächen 13, die parallel zu derselben vertikalen Sägestraße 19 liegen, d.h. eine vertikale Reine von Anschlussflächen bilden, als vertikale Kontaktreihen 18a bezeichnet, während das Bezugszeichen 18b zur Bezeichnung von horizontalen Kontaktreihen verwendet wird.

Die nun folgende Beschreibung bezieht sich zunächst auf das Anbringen von Kontaktelementen 18 an Anschlussflächen 13 von Chips 15 gemäss den Anordnungsmöglichkeiten a) und b).

Zunächst wird eine Folie 16, deren Breite annähernd der Breite einer vertikalen Kontaktreihe 18a entspricht (ca. 50 bis 200 µm), vor einer ersten Anschlussfläche 13 der Kontaktreihe 18a, um eine beabsichtigte Länge 28 des Kontaktelementes 18 abgerollt. Der Kontakt zwischen Folie 16 und Anschlussfläche 13 wird direkt hergestellt. Anschließend wird die Folie 16 horizontal über die vertikale Kontaktreihe 18a um die beabsichtigte Länge 28 des Kontaktelementes 18 abgerollt. Sollte hierbei die Anschlussfläche 13 der nächsten Reihe 26 überschritten werden, so muss die Abrollvorrichtung 10 mittels des Antriebes 9 (s. Fig. 1) bis auf diese Anschlussfläche 13 zurückgeführt werden. Anschließend wird die Folie 16 mit der zweiten Anschlussfläche 13 verbunden.

Dieser Vorgang wird solange wiederholt, bis jede Anschlussfläche 13 der ersten vertikalen Kontaktreihe 18a mit der Folie 16 verbunden ist. Es ergibt sich dann ein Schnittbild, das der Fig. 3a entspricht, wobei die Wellenförmigkeit der Kontaktelemente 18 durch ein eventuelles Zurückführen der Abrollvorrichtung 10 entstehen kann.

Nun kann die Folie 16 jeweils hinter den einzelnen Anschlussflächen 13 der jeweiligen Chips 15 an den Stellen 30 mittels einer Trennvorrichtung 20 (s. Fig. 1) durchtrennt werden, wodurch Chip-Kontaktelemente-Einheiten erhalten werden, deren Kontaktelemente 18 die beabsichtigte Länge 28 aufweisen. Während bei den Anordnungsmöglichkeiten a) und b) die Folie 16 nur jeweils um die beabsichtigte Länge 28 abgerollt wird, muss sie gemäß den Anordnungsmöglichkeiten c) und d) zwischen den Anschlussflächen benachbarter Chips 15 um die doppelte beabsichtigte Länge 29 abgerollt werden. Hierdurch ergibt sich die in Fig. 3b dargestellte Schnittform. Die Folie 16 wird nicht mehr hinter den einzelnen Anschlussflächen 13 der einzelnen Chips 15 durchtrennt, sondern jeweils exakt über den einzelnen Sägestraßen 19, um somit Kontaktelemente 18 mit der jeweils beabsichtigten Länge 28 zu erhalten.

Bevor das Trennen der Folie 16 in die einzelnen Kontaktelemente 18, sowie das Vereinzeln der Chips 15 auf dem Wafer 17 beschrieben wird, sollen an dieser Stelle noch andere Ausführungsformen des Verbindens verschiedenartiger Folien 16 mit den Anschlussflächen 13 der einzelnen Chips 15 auf dem Wafer 17 dargestellt werden.

Fig. 4 ist eine Variante von Fig. 3, die sich dadurch unterscheidet, dass die Breite der Folie 16, die über vertikalen Kontaktreihen 18a abgerollt wird, der Breite von mindestens zwei vertikalen Kontaktreihen 18a entspricht. Die Breite der Folie 16 kann somit variieren zwischen der Breite eines Chips 15 und der Breite des gesamten Wafers 17. Dieser Unterschied bedingt ein Abrollen der Folie 16 um die doppelte beabsichtigte Länge 29 zwischen den Anschlussflächen benachbarter Chips 15 im Falle der Varianten a), c) und d), und ein Abrollen der Folie 16 um eine einfache beabsichtigte Länge 28 zwischen den Anschlussflächen benachbarter Chips 15 im Falle der Variante b). Somit erhält man je nach Anordnung a) - d) der Anschlussflächen 13 auf den Chips 15 verschiedene Schnittbilder, wobei sich für die Anordnungsmöglichkeit b) ein Schnittbild gemäss Fig. 3a und für die Anordnungsmöglichkeiten a), c) und d) ein Schnittbild gemäss Fig. 3b ergibt.

Ansonsten entspricht die Vorgehensweise in Fig. 4 der Vorgehensweise gemäss Fig. 3, wobei die durch die Breite der Folie 16 bedingten elektrischen Verbindungen zwischen den einzelnen Anschlussflächen 13 eines jeden Chips 15 voneinander getrennt werden müssen, bevor die Folie 16 in einzelne Kontaktelemente 18 aufgetrennt wird. Hierzu wird ein zusätzlicher Trennvorgang benötigt, der dem Trennen der Folie 16 in die einzelnen Kontaktelemente 18 und dem anschließenden Vereinzeln der Chips 15 vorangesetzt wird, wobei die Folie 16 entlang von Trennungslinien 30 aufgetrennt wird.

In den Figuren 3 und 4 wurden Verfahren vorgestellt, bei denen jeweils eine Folie 16 unterschiedlicher Breite über einen Wafer 17 mittels einer durch einen Antrieb 9 bewegten Abrollvorrichtung 10 (s. Fig. 1) abgerollt wird und bei denen die ursprüngliche Waferform beibehalten wird, d.h. die Originalabstände der einzelnen Chips 15 zueinander bleiben bestehen. Dabei wurde angenommen, daß die beabsichtigte Länge 28 der Kontaktelemente 18 größer ist als der Abstand der Chips 15, wodurch sich die in den Fig. 3a und 3b gezeigte Wellenförmigkeit beim Abrollen der Folie 16 ergab. Für den Fall, daß die Abstände der Anschlussflächen 13 benachbarter Chips 15 bereits der beabsichtigten Länge 28 der Kontaktelemente 18 entsprechen, kann ein "welliges" Abrollen der Folie 16 vermieden und sogar eine plane Folie 16 über einen kompletten Wafer 17 gelegt werden und an den entsprechenden Stellen mit den Anschlussflächen 13 der einzelnen Chips 15 verbunden werden.

Im folgenden wird eine weitere Möglichkeit beschrieben, wie das Aufbringen der Folie 16 erfolgen kann für den Fall, daß die Abstände zwischen den Chips 15 in bezug auf die beabsichtigte Länge 28 der Kontaktelemente 18 zu gering sind. Wie den nachstehenden Erläuterungen entnehmbar ist, erfolgt in diesem Fall ein "Aufspreizen" der Reihen 26 bzw. Spalten 27, um die Abstände auf das richtige Maß zu vergrößern.

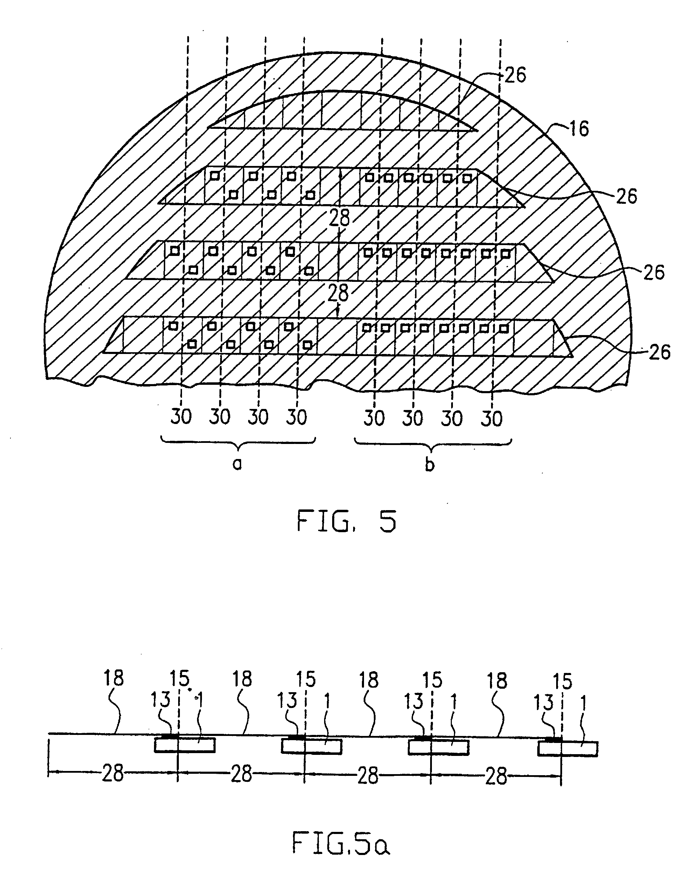

Wie in Fig. 5 angedeutet, kann eine plane Folie 16 über einen "aufgespreizten" Wafer 17 gelegt und an den entsprechenden Stellen mit den Anschlussflächen 13 der einzelnen Chips 15 verbunden werden. Bei diesem Verfahren beträgt der Abstand zwischen ersten horizontalen Kontaktreihen jeweils benachbarter Reihen 26 nach dem Aufspreizen die beabsichtigte Länge 28 der Kontaktelemente 18. Dieses Aufspreizen der Reihen 26 des Wafers 17 bis auf die einfache beabsichtigte Länge 28 ist nur für die Anordnungen a) und b) der Anschlussflächen 13 der Chips 15 möglich. Wird nun die elektrische Verbindung der Anschlussflächen 13 der einzelnen Chips 15 zueinander an entsprechenden Trennungslinien 30 aufgetrennt, so erhält man eine Anordnung gemäss Fig. 5a. Die Länge der Folie 16 zwischen den einzelnen Anschlussflächen 13 der einzelnen Chips 15 entspricht hier der beabsichtigten Länge 28 der Kontaktelemente 18.

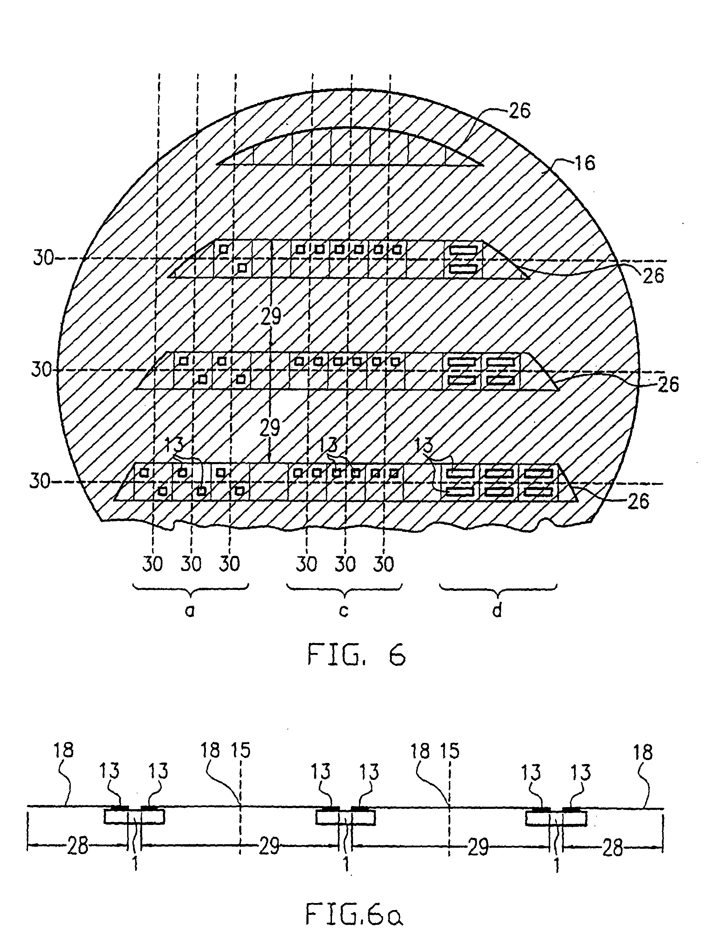

Fig. 6 ist eine Variante von Fig. 5, die sich dadurch unterscheidet, dass die Aufspreizung der Reihen 9 auf die doppelte beabsichtigte Länge 29 der Kontaktelemente 18 durchgeführt wird. Ansonsten entspricht die Vorgehensweise in Fig. 6 der Vorgehensweise gemäss Fig. 5.

Für den Spezialfall der Anordnung a) der Anschlussflächen 13 der Chips, ändert sich die Lage der Trennungslinien 30 zur Trennung der elektrischen Verbindungen zwischen den Anschlussflächen 13 des Chips 15, sowie zur Trennung der Folie 16 in die einzelnen Kontaktelemente 18. Wie man in Fig. 6a erkennen kann, wird die Trennung der Folie 16 in die einzelnen Kontaktelemente 18 mittig zwischen zwei benachbarten Reihen 26 des Wafers 17 durchgeführt.

Bei den Figuren 5 und 6 kann das Erstellen der elektrischen Verbindung zwischen der Folie 16 und den Anschlussflächen 13 der einzelnen Chips 15 auf verschiedene Arten und Weisen erfolgen. Möglichkeiten hierzu sind Druck, Temperatur oder Ultraschall, wobei die einzelnen Reihen 26 sequentiell von einer Verbindungsvorrichtung 10 mittels eines Antriebes 9 (s. Fig. 1) durchlaufen werden. Es können auch mehrere parallele Verbindungsvorrichtungen 10 zum Einsatz kommen. Des weiteren können die verschiedenen Verfahren miteinander kombiniert werden, d.h. die in den Figuren 5 und 6 beschriebene Aufspreizung der Reihen 26 des Wafers 17 vor dem Aufbringen der Folie 16 könnte in den nach Fig. 3 und 4 beschriebenen Verfahren auch nach der Verbindung der Folie 16 mit den Anschlussflächen 13 der einzelnen Chips 15 erfolgen. Hierdurch würde eine Anordnung nach Fig. 3a in eine Anordnung nach Fig. 5a überführt werden, bzw. eine Anordnung nach Fig. 3b in eine Anordnung nach Fig. 6b.

Je nach Zeitpunkt der Durchführung des Trennvorgangs der Folie 16 in die einzelnen Kontaktelemente 18 entstehen Chip-Kontaktelemente-Einheiten, bestehend aus Chips 15 mit Kontaktelementen 18, die dann verschiedene Möglichkeiten für die weitere Verarbeitung eben dieser Einheiten eröffnen. Diese verschiedenen Möglichkeiten werden nachfolgend beschrieben.

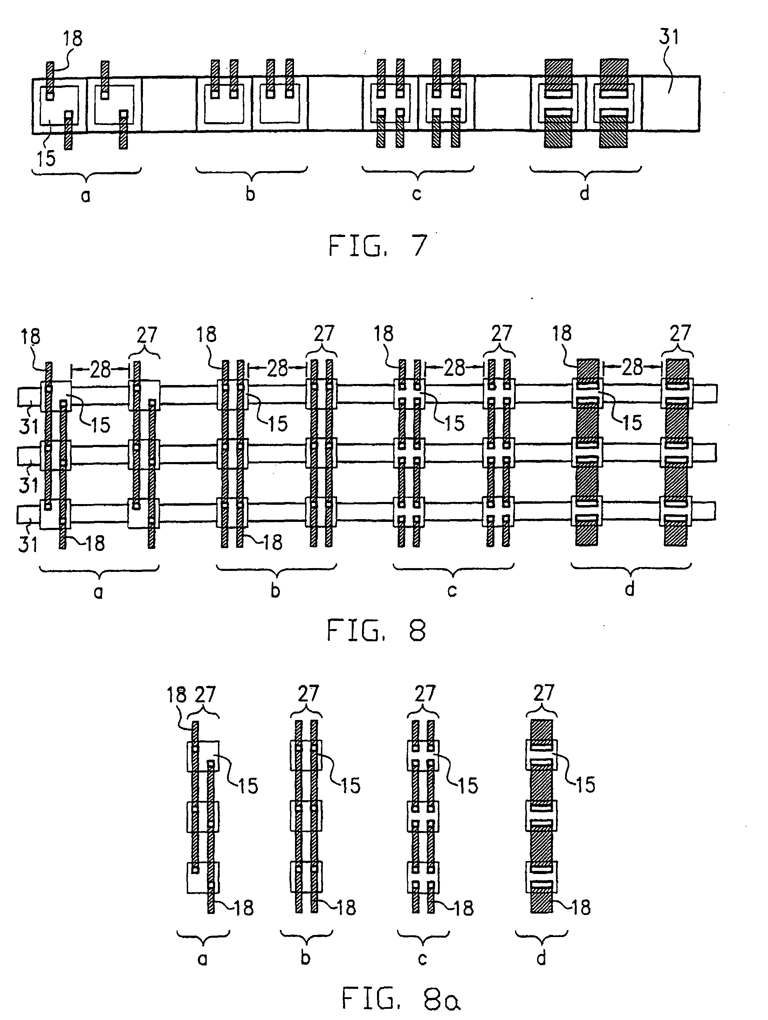

In Fig. 7 wird eine schematische Ansicht eines Trägerbandes 31 mit vier beispielhaft angedeuteten Möglichkeiten a) - d) zur Aufnahme von Chip-Kontaktelemente-Einheiten gezeigt, wobei diese vier Möglichkeiten bedingt sind durch die verschiedenen Anordnungsmöglichkeiten der Anschlussflächen 13 auf den Chips 15, gemäss Fig. 2, a - d.

Nachdem die Folie 16 vorzugsweise mittels eines Lasers in die einzelnen Kontaktelemente 18 entlang von Trennungslinien 30 aufgetrennt wurde (s. Fig. 3a-b, 5a und 6a), werden die Chip-Kontaktelemente-Einheiten einzeln aus der durch den Wafer 17 (s. Fig. 3 - 6) vorgegebenen Gruppierung gelöst und sequentiell auf das Trägerband 31 in vorgegebenen Abständen (nicht gezeigt) zueinander aufgebracht, wobei die einzelnen Kontaktelemente 18 senkrecht zu den Chipkanten der einzelnen Chips 15 und somit auch senkrecht vom Trägerband 31 abstehen.

Fig. 8 zeigt eine schematische Ansicht von Trägerbändern 31 mit vier beispielhaft angedeuteten Möglichkeiten a) - d) zur Aufnahme von Chip-Kontaktelemente-Einheiten, wobei diese vier Möglichkeiten den verschiedenen Anordnungsmöglichkeiten der Anschlussflächen 13, gemäss Fig. 2, entsprechen. Im Unterschied zu Fig. 7 werden hier Spalten 27 des Wafers 17 aufgespreizt, wobei vorzugsweise die einzelnen Reihen 26 bereits aufgespreizt sind. Der bevorzugte Abstand zwischen den einzelnen Spalten 27 sollte einer beabsichtigten Länge 17 eines Kontaktelementes 18 entsprechen, er ist jedoch grundsätzlich anwendungsabhängig und somit nicht zwingend erforderlich.

Unter die aufgespreizten Reihen 26 der aufgespreizten Spalten 27 können nun Trägerbänder 31 aufgebracht werden. Das Aufbringen dieser Trägerbänder 19 kann mittels eines Klebers erfolgen, der vorzugsweise UV-lösbar ist. Der Abstand der Trägerbänder 31 zueinander wird bestimmt durch die verschiedenen Anordnungsmöglichkeiten a) - d) der Anschlussflächen 13 der einzelnen Chips 15.

Fig. 8a zeigt eine schematische Ansicht von aneinandergereihten Chip-Kontaktelemente-Einheiten mit vier beispielhaft angedeuteten Möglichkeiten a) - d) zur Aneinanderreihung verschiedener Spalten von Chip-Kontaktelemente-Einheiten, wobei diese vier Möglichkeiten den verschiedenen Anordnungsmöglichkeiten der Anschlussflächen 13, gemäss Fig. 2, entsprechen und die unaufgetrennten Kontaktelemente 18 die Funktion von Trägerbändern übernehmen.

Ein prinzipieller Vorteil des Aneinanderreihens von Chip-Kontaktelemente-Einheiten gemäß Fig. 8 bzw. Fig. 8a besteht in einer guten Transportfähigkeit sowie in einer einfachen maschinellen Handhabung.

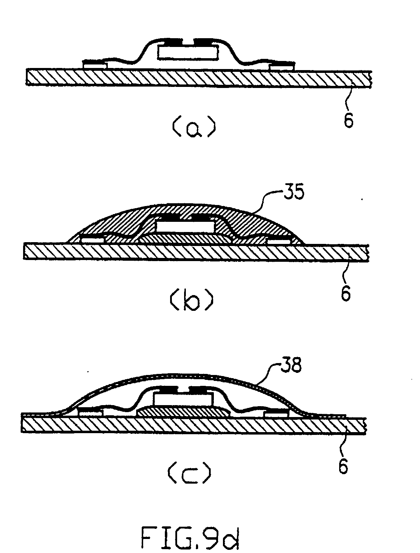

Eine direkte Verarbeitung der einzelnen Chip-Kontaktelemente-Einheiten kann nach dem Vereinzeln der Einheiten auch direkt, d.h. ohne vorher auf ein Trägerband aufgebracht zu worden zu sein, erfolgen. In diesem Fall können die Einheiten direkt aus der Gruppierung, die durch den Wafer vorgegeben wird, entnommen werden und, wie in den Figuren 9 und 9a angedeutet, mit den Kontaktanschlüssen der Antennenspule 33 elektrisch leitend verbunden werden.

Gemäß Fig. 9b kann die Chip-Kontaktelemente-Einheit mit dem Chipkartenkörper 6 verbunden werden, vorzugsweise mittels Klebens 24, wobei als Klebstoff z.B. ein strahlungshärtbarer Klebstoff, vorzugsweise ein durch UV-Licht einer vorbestimmten Wellenlänge zur Polymerisation aktivierbarer Acrylat- oder Epoxid Klebstoff, verwendet werden kann. Da hierbei der Chip 15 selbst fest mit dem Chipkartenkörper 6 verbunden wird, wird in den nachstehenden Erläuterungen beschrieben, wie im Fall einer Dehnung bzw. Biegung des Chipkartenkörpers vermieden werden kann, dass der Chip 15 bzw. die Kontaktelemente 18 mechanisch überbelastet und ggf. beschädigt werden.

Zum Schutz vor einer Überbelastung kann eine Zugentlastung des Chips 15 erreicht werden, indem entweder ein dehnbarer Klebstoff zum Aufkleben des Chips 15 auf den Chipkartenkörper 6 verwendet wird, indem der Chipkartenkörper 6 unter dem Chip 15 selbst dehnbar ausgestaltet wird, oder indem eine Abschwächung bzw. Verstärkung des Chipbereichs erfolgt, was im folgenden beschrieben wird.

Fig. 9c zeigt schematische Seitenansichten einer ankontaktierten, mit dem Chipkartenkörper 6 verbundenen Chip-Kontaktelemente-Einehit mit vier beispielhaft angedeuteten Möglichkeiten a) bis d) zur Zugentlastung des Chipbereichs. Die Möglichkeit a) zeigt einen Chipkartenkörper 6, der in der Umgebung des Chipbereichs dünner ausgestaltet wird, um somit Sollbiegestellen 23 zu schaffen, die im Falle der Dehnung bzw. Biegung des Chipkartenkörpers 6 eine Zugentlastung des Chips 15 bewirken können. An die Stelle des Verdünnens des Chipkartenkörpers 6 in den dargestellten Bereichen 23 kann ein Anbringen eines anderen Materials 25 treten, das dehnbarer ist als der Chipkartenkörper 6, was in Möglichkeit b) dargestellt wird. Für den Fall, dass der Chipkartenkörper 6 weder um den Chipbereich herum verdünnt werden soll noch ein Aufbringen eines anderen Materials erwünscht ist, kann die Zugentlastung des Chips durch eine Perforation 36, die um den Chipbereich angeordnet wird, erreicht werden, was in der Möglichkeit c) angedeutet ist.

In einer anderen Variante, dargestellt durch die Möglichkeit d), wird die Umgebung des Chipbereichs nicht abgschwächt, sondern durch die Aufbringung eines zusätzlichen Materials 37 verstärkt. Somit kann erreicht werden, daß der Bereich um den Chip 15 weniger dehnbar wird als der Rest des Chipkartenkörpers 6, womit wiederum eine Zugentlastung des Chips 15 erreicht werden kann.
In den oben beschriebenen vier Möglichkeiten a) bis d) zur Zugentlastung eines mit dem Chipkartenkörper 6 verbundenen Chips 15 ist jeweils angedeutet, wie zusätzlich zur Zugentlastung des Chips 15 eine Zugentlastung der Kontaktelemente 18 bewirkt werden kann. Diese Zugentlastung der Kontaktelemente 18 wird dadurch erreicht, daß die Kontaktelemente 18 länger ausgelegt werden als der Abstand zwischen den Kontaktanschlüssen 3 und den Anschlußflächen 13 des Chips 15, sodass die Kontaktelemente 18 bei der Kontaktierung in eine wellenförmige Form gebracht werden können.

Die Wellenförmigkeit der Kontaktelemente 18 kann auch für den Fall, daß der Chip 15 nicht wie in den oben beschriebenen Fällen mit dem Chipkartenkörper 6 verbunden wird, zur Zugentlastung der Kontaktelemente 18 verwendet werden. Insbesondere kann auch für diesen Fall eine Zugentlastung des Chips 15 erreicht werden, was im folgenden beschrieben wird.

Fig. 9d zeigt schematische Seitenansichten einer ankontaktierten Chip-Kontaktelemente-Einheit, die nicht mit dem Chipkartenkörper 6 verbunden wird und deren Chipbereich zugentlastet ist, was mit den drei beispielhaft angedeuteten Möglichkeiten a) bis c) dargestgellt wird. In Möglichkeit a) ist der Chip 15 nicht mit dem Chipkartenkörper 6 verbunden, sodass der Chip 15 selbst bei einem Biegen bzw. Dehnen des Chipkartenkörpers 6 nicht beansprucht wird, da nur der Chipkartenkörper 6, nicht aber der Chip 15, gedehnt bzw. gebogen werden kann. Die somit erreichte Zugentlastung des Chips 15 kann auch dann erreicht werden, wenn der Chip 15, wie in Möglichkeit b) dargestellt, mit einer Abdeckmasse 35 vergossen wird. Damit auch in diesem Fall der Chip 15 bei einer Dehnung bzw. Biegung des Chipkartenkörpers 6 nicht beansprucht wird, wird die Abdeckmasse 35 so gewählt, daß sie dehnbarer ist als der Chipkartenkörper 6. Gemäss einer anderen Variante, gezeigt in Möglichkeit c), kann der Chip 15 auch mit einer Abdeckfolie 38 abgedeckt werden, wobei eine klebende bzw. haftende Verbindung der Abdeckfolie 38 mit der Chip-Kontaktelemente-Einheit vermieden werden sollte, um somit die Zugentlastung des Chips 15 sicherzustellen.

## Patentansprüche

1. Verfahren zur Herstellung von elektrischen Einheiten bestehend aus Chips (15) mit Kontaktelementen (18), wobei die Kontaktelemente (18) geeignet sind, direkt mit Kontaktanschlüssen (3) externer elektrischer Bauelemente (6) elektrisch leitend verbunden zu werden, wobei
jeder Chip (15) eine aktive Fläche mit mindestens einer Anschlussfläche (13) und eine nicht-aktive Fläche, die der aktiven Fläche gegenüberliegt, aufweist;
die Verbindung der Kontaktelemente (18) mit jeweils mindestens einer Anschlussfläche (13) der Chips (15) erfolgt, bevor die einzelnen Chips (15) aus einer durch einen Wafer (17) vorgegebenen Gruppierung, bestehend aus Reihen (26) und Spalten (27), ausgelöst werden; und
die Kontaktelemente (18) aus einer flexiblen, auf die Chips (15) aufzubringenden metallisierten Kunststoff-Folie und/oder metallischen Folie (16) ausgebildet werden,
**dadurch gekennzeichnet, dass**
jedes Kontaktelement (18) so ausgebildet wird, dass es eine Form und Länge aufweist, die ermöglicht, dass das Kontaktelement (18) nach dem Auslösen der entsprechenden elektrischen Einheit aus der durch den Wafer (17) vorgegebenen Gruppierung bis zu der Ebene reicht, die mit der nicht-aktiven Fläche des Chips (15) zusammenfällt.

2. Verfahren nach Anspruch 1, **dadurch gekennzeichnet, dass** die vorgegebene Gruppierung durch Sägen des Wafers (17) in Reihen (26) und Spalten (27) definiert wird.

3. Verfahren nach den Ansprüchen 1 oder 2, **dadurch gekennzeichnet, dass** die durch den Wafer (17) vorgegebene Gruppierung auf eine klebende Haltefolie (11) in einem Halterahmen (12) aufgebracht wird.

4. Verfahren nach den Ansprüchen 1 oder 2, **dadurch gekennzeichnet, dass** die durch den Wafer (17) vorgegebene Gruppierung auf ein Halte-Substrat aufgebracht wird.

5. Verfahren nach einem der Ansprüche 1 bis 4, **dadurch gekennzeichnet, dass** die auf die Chips (15) aufzubringende metallisierte Kunststoff-Folie bzw. metallische Folie (16) strukturiert ist, um dadurch die Form der Kontaktelemente (18) vorzudefinieren.

6. Verfahren nach einem der Ansprüche 1 bis 5, **dadurch gekennzeichnet, dass** die auf die Chips (15) aufzubringende metallisierte Kunststoff-Folie bzw. metallische Folie (16) aus Gold ist.

7. Verfahren nach einem der Ansprüche 1 bis 6, **dadurch gekennzeichnet, dass** die auf die Chips (15) aufzubringende metallisierte Kunststoff-Folie bzw. metallische Folie (16) mindestens die Breite einer Anschlussfläche (13) aufweist.

8. Verfahren nach einem der Ansprüche 1 bis 7, **dadurch gekennzeichnet, dass** die Verbindung der Folie mit den einzelnen Chips (15) an mindestens zwei Anschlussflächen (13) jedes einzelnen Chips (15) erfolgt.

9. Verfahren nach Anspruch 8, **dadurch gekennzeichnet, dass** die Verbindung der Folie mit den einzelnen Chips (15) an zwei Anschlussflächen (13) jedes einzelnen Chips (15) erfolgt und die zwei Anschlussflächen (13) jeweils in gleichem Abstand zu einer Seite des jeweiligen Chips (15) angeordnet sind, sodass die Anschlussflächen (13) der Chips (15) einer Reihe (26) gemeinsam eine Kontaktreihe (18b) bilden.

10. Verfahren nach Anspruch 8, **dadurch gekennzeichnet, dass** die Verbindung der Folie mit den einzelnen Chips (15) an zwei Anschlussflächen (13) jedes einzelnen Chips (15) erfolgt und die zwei Anschlussflächen (13) jeweils in unterschiedlichen Abständen zu einer Seite des jeweiligen Chips (15) angeordnet sind, wobei die zwei Anschlussflächen (13) des jeweiligen Chips (15) diagonal versetzt angeordnet sind, sodass die Anschlussflächen (13) der Chips (15) einer Reihe (26) zwei Kontaktreihen (18b) bilden.

11. Verfahren nach Anspruch 10, **dadurch gekennzeichnet, dass** die Breite der Anschlussflächen (13) etwa der Breite des Chips (15) entspricht und die zwei Anschlussflächen (13) des jeweiligen Chips (15) an gegenüberliegenden Seiten des jeweiligen Chips (15) angeordnet sind.

12. Verfahren nach Anspruch 8, **dadurch gekennzeichnet, dass** die Verbindung der Kontaktelemente (18) mit den einzelnen Chips (15) an vier Anschlussflächen (13) jedes einzelnen Chips (15) erfolgt, wobei die Anschlussflächen (13) jeweils in den Ecken des jeweiligen Chips (15) liegen, sodass die Anschlussflächen (13) aller Chips (15) einer Reihe (26) zwei Kontaktreihen (18b) bilden.

13. Verfahren nach Anspruch 9 oder 10, **gekennzeichnet durch** die folgenden Schritte,
Verbinden der metallisierten Kunststofffolie bzw. metallischen Folie (16) mit einer ersten Anschlussfläche (13),
Abrollen der Folie (16) jeweils entsprechend der beabsichtigten Länge (28) zwischen der ersten Anschlussfläche (13) und einer zweiten Anschlussfläche (13) in einer benachbarten Reihe (26),
Verbinden der Folie (16) mit der zweiten Anschlussfläche (13),
Schneiden der Folie (16).

14. Verfahren nach einem der Ansprüche 10 bis 12, **gekennzeichnet durch** die folgenden Schritte,
Verbinden der metallisierten Kunststofffolie bzw. metallischen Folie (16) mit einer ersten Anschlussfläche (13),
Abrollen der Folie (16) jeweils entsprechend der doppelten beabsichtigten Länge (29) zwischen der ersten Anschlussfläche (13) und einer zweiten Anschlussfläche (13) in einer benachbarten Reihe (26).
Verbinden der Folie (16) mit der zweiten Anschlussfläche (13),
Schneiden der Folie (16).

15. Verfahren nach Anspruch 13 oder 14, **dadurch gekennzeichnet, dass** das Schneiden der metallisierten Kunststofffolie bzw. metallischen Folie (16) nach dem vollständigen Verbinden der Folie (16) erfolgt.

16. Verfahren nach Anspruch 9 oder 10, **dadurch gekennzeichnet, dass** die Reihen (26) vor dem Aufbringen der Folie (16) so voneinander beabstandet werden, dass der Abstand zwischen Kontaktreihen (18b) benachbarter Reihen (26) der beabsichtigten Länge (28) der Kontaktelemente (18) entspricht.

17. Verfahren nach einem der Ansprüche 10 bis 12, **dadurch gekennzeichnet, dass** die Reihen (26) vor dem Aufbringen der Folie (16) so voneinander beabstandet werden, dass der Abstand zwischen Kontaktreihen (18b) benachbarter Reihen (26) der doppelten beabsichtigten Länge (29) der Kontaktelemente (18) entspricht.

18. Verfahren nach einem der Ansprüche 9, 10, 16 oder 17, **gekennzeichnet durch** die folgenden Schritte,
Auflegen der metallisierten Kunststofffolie bzw. metallischen Folie (16) auf den Wafer (17),
Verbinden der Folie (16) mit allen Anschlussflächen (13),
Schneiden der Folie (16).

19. Verfahren nach einem der Ansprüche 13, 14 oder 18, **dadurch gekennzeichnet, dass** das Verbinden der Chips (15) mit der metallisierten Kunststofffolie bzw. metallischen Folie (16) durch einen Löt-, Bond- oder Klebeprozess ausgeführt wird.

20. Verfahren nach einem der Ansprüche 13, 14 oder 18, **dadurch gekennzeichnet, dass** das Schneiden der metallisierten Kunststofffolie bzw. metallischen Folie (16) mittels eines Lasers erfolgt.

21. Verfahren zum Herstellen von Trägerbändern (31) zur Aufnahme von gemäß den Ansprüchen 1 - 20 gefertigten Chip-Kontaktelemente-Einheiten, **dadurch gekennzeichnet, dass** die aus der Gruppierung ausgelösten Chip-Kontakt-elemente-Einheiten derart auf die Trägerbänder (31) aufgebracht werden, dass alle Chips (15) eines Wafers (17) von demselben Trägerband (31) aufgenommen werden.

22. Verfahren nach Anspruch 21, **dadurch gekennzeichnet, dass** die Kontaktelemente (18) der Chip-Kontaktelemente-Einheiten senkrecht zu den Trägerbändern (31) stehen

23. Verfahren nach Anspruch 21, **dadurch gekennzeichnet, dass** die unaufgetrennten Kontaktelemente (18) einzelner Spalten von Chip-Kontaktelemente-Einheiten als Trägerbänder (31) verwendet werden.

## Claims

1. Method of producing electrical units consisting of chips (15) with contact elements (18), wherein the contact elements (18) are suited for the direct connection with contact terminals (3) of external electric components (6) in an electrically conductive fashion, wherein
each chip (15) has an active surface with at least one bond pad (13) and a non-active surface arranged opposite the active surface;
the connection of the contact elements (18) with at least one bond pad (13) of the chips (15) is effected before the individual chips (15) are removed from the grouping predefined by a wafer (17) and consisting of rows (26) and columns (27); and
the contact elements (18) are made of a flexible metallized plastic foil and/or metallic foil (16) to be applied onto the chips (15),
**characterized in that**
each contact element (18) is constructed such that it has a form and length permitting the contact element (18) after the removal of the corresponding electric unit from the grouping predefined by the wafer (17) to reach the plane which coincides with the non-active surface of the chip (15).

2. Method according to claim 1, **characterized in that** the predefined grouping is defined by sawing the wafer (17) into rows (26) and columns (27).

3. Method according to claims 1 or 2, **characterized in that** the grouping predefined by the wafer (17) is applied onto an adhesive holding foil (11) in a holding frame (12).

4. Method according to one of claims 1 or 2, **characterized in that** the grouping predefined by the wafer (17) is applied onto a holding substrate.

5. Method according to one of claims 1 to 4, **characterized in that** the metallized plastic foil or metallic foil (16) to be applied onto the chips (15) is structured so as to predefine the form of the contact elements (18).

6. Method according to one of claims 1 to 5, **characterized in that** the metallized plastic foil or metallic foil (16) to be applied onto the chips (15) is made of gold.

7. Method according to one of claims 1 to 6, **characterized in that** the metallized plastic foil or metallic foil (16) to be applied onto the chips (15) at least has the width of a bond pad (13).

8. Method according to one of claims 1 to 7, **characterized in that** the connection of the foil with the individual chips (15) is effected on at least two bond pads (13) of each individual chip (15).

9. Method according to claim 8, **characterized in that** the connection of the foil with the individual chips (15) is effected on two bond pads (13) of each individual chip (15) and the two bond pads (13) are each arranged at the same distance to one side of the respective chip (15) so that the bond pads (13) of the chip (15) of one row (26) together form a contact row (18b).

10. Method according to claim 8, **characterized in that** the connection of the foil with the individual chips (15) is effected on two bond pads (13) of each individual chip (15) and the two bond pads (13) are each arranged at different distances to one side of the respective chip (15), wherein the two bond pads (13) of the respective chip (15) are arranged in a diagonally offset manner so that the bond pads (13) of the chips (15) of one row (26) form two contact rows (18b).

11. Method according to claim 10, **characterized in that** the width of the bond pads (13) correspond approximately to the width of the chip (15) and that the two bond pads (13) of the respective chip (15) are arranged at opposite sides of the respective chip (15).

12. Method according to claim 8, **characterized in that** the connection of the contact elements (18) with the individual chips (15) is effected on four bond pads (13) of each individual chip (15), wherein the bond pads (13) are each located in the corners of the respective chip (15) so that the bond pads (13) of all chips (15) of one row (26) form two contact rows (18b).

13. Method according to claim 9 or 10, **characterized by** the following steps:
connecting the metallized plastic foil or metallic foil (16) with a first bond pad (13),
unrolling the foil (16) in correspondence with the intended length (28) between the first bond pad (13) and a second bond pad (13) in an adjacent row (26),
connecting the foil (16) with the second bond pad (13),
cutting the foil (16).

14. Method according to one of claims 10 to 12, **characterized by** the following steps:
connecting the metallized plastic foil or metallic foil (16) with a first bond pad (13),
unrolling the foil (16) in correspondence with double the intended length (29) between the first bond pad (13) and a second bond pad (13) in an adjacent raw (26),
connecting the foil (16) with the second bond pad (13),
cutting the foil (16).

15. Method according to claim 13 or 14, **characterized in that** the cutting of the metallized plastic foil or metallic foil (16) is effected after the complete connection of the foil (16).

16. Method according to claim 9 or 10, **characterized in that** the rows (26) are spaced apart from each other prior to the application of the foil (16) such that the distance between contact rows (18b) of adjacent rows (26) corresponds to the intended length (28) of the contact elements (18).

17. Method according to one of claims 10 to 12, **characterized in that** the rows (26) are spaced apart from each other prior to the application of the foil (16) such that the distance between contact rows (18b) of adjacent rows (26) corresponds to double the intended length (29) of the contact elements (18).

18. Method according to one of claims 9, 10, 16 or 17, **characterized by** the following steps:
placing the metallized plastic foil or metallic foil (16) onto the wafer (17),
connecting the foil (16) with all bond pads (13),
cutting the foil (16).

19. Method according to one of claims 13, 14 or 18, **characterized in that** the connection of the chips (15) with the metallized plastic foil or metallic foil (16) is performed with a soldering, bonding or gluing process.

20. Method according to one of claims 13, 14 or 18, **characterized in that** the cutting of the metallized plastic foil or metallic foil (16) is effected by means of a laser.

21. Method of producing carrier substrates (31) for receiving chip contact element units produced according to claims 1 to 20, **characterized in that** the chip contact element units removed from the grouping are applied onto the carrier substrates (31) such that all chips (15) of a wafer (17) are received by the same carrier substrate (31).

22. Method according to claim 21, **characterized in that** the contact elements (18) of the chip contact element units stand perpendicularly to the carrier substrates (31).

23. Method according to claim 21, **characterized in that** the non-separated contact elements (18) of individual columns are used by chip contact element units as carrier substrates (31).

## Revendications

1. Procédé pour produire des unités électriques constituées de puces (15) à éléments de contact (18), les éléments de contact (18) étant appropriés pour être reliés directement par conduction électrique avec des plots de contact (3) de composants électriques (6) externes, dans lequel
chaque puce (15) comporte une surface active ayant au moins une surface de contact (13) et une surface non active, qui est située en face de la surface active ;
la liaison entre chaque élément de contact (18) et au moins une surface de contact (13) des puces (15) est établie avant que les puces individuelles (15) soient détachées d'un groupement prédéfini par une plaquette (17) et formé par des rangées (26) et des colonnes (27) ; et
les éléments de contact (18) sont réalisés dans une feuille de matière plastique métallisée et/ou une feuille métallique (16) flexible à appliquer sur les puces (15)
**caractérisé en ce que**
chaque élément de contact (18) est conçu de telle sorte qu'il possède une forme et une longueur qui permettent que l'élément de contact (18), une fois que l'unité électrique correspondante a été détachée du groupement prédéfini par la plaquette (17), s'étende jusqu'au plan qui coïncide avec la surface non active de la puce (15).

2. Procédé selon la revendication 1, **caractérisé en ce que** le groupement prédéfini est défini en rangées (26) et colonnes (27) par sciage de la plaquette (17).

3. Procédé selon les revendications 1 ou 2, **caractérisé en ce que** le groupement prédéfini par la plaquette (17) est déposé sur une feuille de support (11) adhésive dans un cadre de support (12).

4. Procédé selon la revendication 1 ou 2, **caractérisé en ce que** le groupement prédéfini par la plaquette (17) est déposé sur un substrat de support.

5. Procédé selon l'une des revendications 1 à 4, **caractérisé en ce que** la feuille de matière plastique métallisée ou feuille métallique (16) à appliquer sur les puces (15) est structurée pour prédéfinir ainsi la forme des éléments de contact (18).

6. Procédé selon l'une des revendications 1 à 5, **caractérisé en ce que** la feuille de matière plastique métallisée ou feuille métallique (16) à appliquer sur les puces (15) est en or.

7. Procédé selon l'une des revendications 1 à 6, **caractérisé en ce que** la feuille de matière plastique métallisée ou feuille métallique (16) à appliquer sur les puces (15) présente au moins la largeur d'une surface de contact (13).

8. Procédé selon l'une des revendications 1 à 7, **caractérisé en ce que** la feuille est assemblée aux puces individuelles (15) sur au moins deux surfaces de contact (13) de chaque puce individuelle (15).

9. Procédé selon la revendication 8, **caractérisé en ce que** la feuille est assemblée aux puces individuelles (15) sur deux surfaces de contact (13) de chaque puce individuelle (15) et les deux surfaces de contact (13) sont agencées chacune à même distance d'un côté de la puce (15) concernée, de telle sorte que les surfaces de contact (13) des puces (15) d'une rangée (26) forment ensemble une rangée de contact (18b).

10. Procédé selon la revendication 8, **caractérisé en ce que** la feuille est assemblée aux puces individuelles (15) sur deux surfaces de contact (13) de chaque puce individuelle (15) et les deux surfaces de contact (13) sont agencées chacune à des distances différentes d'un côté de la puce (15) concernée, les deux surfaces de contact (13) de la puce concernée (15) étant décalées en diagonale, de telle sorte que les surfaces de contact (13) des puces (15) d'une rangée (26) forment deux rangées de contact (18b).

11. Procédé selon la revendication 10, **caractérisé en ce que** la largeur des surfaces de contact (13) correspond pratiquement à la largeur de la puce (15) et les deux surfaces de contact (13) de chaque puce individuelle (15) sont agencées sur des côtés face à face de chacune des puces (15).

12. Procédé selon la revendication 8, **caractérisé en ce que** les éléments de contact (18) sont reliés aux puces individuelles (15) sur quatre surfaces de contact (13) de chaque puce individuelle (15), les surfaces de contact (13) étant disposées respectivement dans les angles de la puce (15) concernée, de telle sorte que les surfaces de contact (13) de toutes les puces (15) d'une rangée (26) forment deux rangées de contact (18b).

13. Procédé selon la revendication 9 ou 10, **caractérisé par** les étapes suivantes,
assemblage de la feuille de matière plastique métallisée ou feuille métallique (16) avec une première surface de contact (13),
déroulement de la feuille (16) chaque fois en correspondance de la longueur (28) voulue entre la première surface de contact (13) et une deuxième surface de contact (13) dans une rangée (26) voisine,
assemblage de la feuille (16) avec la deuxième surface de contact (13),
découpe de la feuille (16).

14. Procédé selon l'une des revendications 10 à 12, **caractérisé par** les étapes suivantes,
assemblage de la feuille de matière plastique métallisée ou feuille métallique (16) avec une première surface de contact (13),
déroulement de la feuille (16) chaque fois en correspondance de la double longueur (29) voulue entre la première surface de contact (13) et une deuxième surface de contact (13) dans une rangée (26) voisine,
assemblage de la feuille (16) avec la deuxième surface de contact (13),
découpe de la feuille (16).

15. Procédé selon la revendication 13 ou 14, **caractérisé en ce que** la découpe de la feuille de matière plastique métallisée ou feuille métallique (16) est effectuée après l'assemblage complet de la feuille (16).

16. Procédé selon la revendication 9 ou 10, **caractérisé en ce que** les rangées (26), avant la pose de la feuille (16), sont écartées les unes des autres de telle sorte que la distance entre des rangées de contact (18b) de rangées (26) voisines correspond à la longueur (28) voulue des éléments de contact (18).

17. Procédé selon l'une des revendications 10 à 12, **caractérisé en ce que** les rangées (26), avant la pose de la feuille (16), sont écartées les unes des autres de telle sorte que la distance entre des rangées de contact (18b) de rangées (26) voisines correspond à la double longueur (29) voulue des éléments de contact (18).

18. Procédé selon l'une des revendications 9, 10, 16 ou 17, **caractérisé par** les étapes suivantes,
pose de la feuille de matière plastique métallisée ou feuille métallique (16) sur la plaquette (17),
assemblage de la feuille (16) avec toutes les surfaces de contact (13),
découpe de la feuille (16).

19. Procédé selon l'une des revendications 13, 14 ou 18, **caractérisé en ce que** les puces (15) sont assemblées à la feuille de matière plastique métallisée ou feuille métallique (16) par un processus de brasage, d'adhésion ou de collage.

20. Procédé selon l'une des revendications 13, 14 ou 18, **caractérisé en ce que** la découpe de la feuille de matière plastique métallisée ou feuille métallique (16) est effectuée au moyen d'un laser.

21. Procédé pour produire des bandes de support (31) pour recevoir des unités électriques à éléments de contact en puces fabriquées selon les revendications 1 à 20, **caractérisé en ce que** les unités à éléments de contact en puces détachées du groupement sont appliquées sur les bandes de support (31) de telle sorte que toutes les puces (15) d'une plaquette (17) sont reçues par la même bande de support (31).

22. Procédé selon la revendication 21, **caractérisé en ce que** les éléments de contact (18) des unités à éléments de contact en puces sont agencés perpendiculairement aux bandes de support (31).

23. Procédé selon la revendication 21, **caractérisé en ce que** les éléments de contact (18) non séparés des colonnes individuelles des unités à éléments de contact en puces sont utilisés comme bandes de support (31).
